(19) Europäisches Patentamt
European Patent Office
Office européen des brevets

(11) **EP 1 816 742 B1**

(12) **EUROPÄISCHE PATENTSCHRIFT**

(45) Veröffentlichungstag und Bekanntmachung des Hinweises auf die Patenterteilung:
**03.07.2013 Patentblatt 2013/27**

(51) Int Cl.:
*H03F 3/191* (2006.01)     *H03F 3/45* (2006.01)
*H03F 1/56* (2006.01)

(21) Anmeldenummer: **07001562.3**

(22) Anmeldetag: **25.01.2007**

(54) **Differenzverstärker und Funksystem mit Differenzverstärker**

Differential amplifier and radio system with differential amplifier

Amplificateur différentiel et système radio doté d'un amplificateur différentiel

(84) Benannte Vertragsstaaten:
**DE FR**

(30) Priorität: **01.02.2006 DE 102006004952**

(43) Veröffentlichungstag der Anmeldung:
**08.08.2007 Patentblatt 2007/32**

(73) Patentinhaber: **Atmel Automotive GmbH**
**74072 Heilbronn (DE)**

(72) Erfinder: **Kluge, Wolfram, Dr.**
**01109 Dresden (DE)**

(74) Vertreter: **Grünecker, Kinkeldey,**
**Stockmair & Schwanhäusser**
**Leopoldstrasse 4**
**80802 München (DE)**

(56) Entgegenhaltungen:
EP-A- 1 067 679     US-B1- 6 392 486

• GRAMEGNA G ET AL: "An 8.2-ghz, 14.4mw, 1.6db nf sige bipolar lna with dc current reuse" PROCEEDINGS OF THE 2003 BIPOLAR/BICMOS CIRCUITS AND TECHNOLOGY MEETING. ( BCTM ). TOULOUSE, FRANCE, SEPT. 28 - 30, 2003, IEEE BIPOLAR/BICMOS CIRCUITS AND TECHNOLOGY MEETING, NEW YORK, NY : IEEE, US, 28. September 2003 (2003-09-28), Seiten 49-52, XP010688453 ISBN: 0-7803-7800-8

• CHE-HONG LIAO ET AL: "A 5.7-GHz 0.18-/spl mu/m CMOS gain-controlled differential LNA with current reuse for WLAN receiver" IEEE MICROWAVE AND WIRELESS COMPONENTS LETTERS, IEEE SERVICE CENTER, NEW YORK, NY, US, Bd. 13, Nr. 12, Dezember 2003 (2003-12), Seiten 526-528, XP011106056 ISSN: 1531-1309

• RAGONESE E ET AL: "A 5-GHz monolithic silicon bipolar down-converter with on-chip image filtering", ELECTROTECHNICAL CONFERENCE, 2004. MELECON 2004. PROCEEDINGS OF THE 12 TH IEEE MEDITERRANEAN DUBROVNIK, CROATIA 12-15 MAY 2004, PISCATAWAY, NJ, USA,IEEE, US, 12 May 2004 (2004-05-12), pages 159-162Vol.1, XP010733752, DOI: 10.1109/MELCON.2004.1346797 ISBN: 978-0-7803-8271-8

• GRAMEGNA G ET AL: "23mm<2> single_chip 0.18/spl mu/m CMOS GPS receiver with 28mW-4.1 mm<2> radio and CPU/DSP/RAM/ROM", CUSTOM INTEGRATED CIRCUITS CONFERENCE, 2004. PROCEEDINGS OF THE IEEE 2004, IEEE, PISCATAWAY, NJ, USA, 3 October 2004 (2004-10-03), pages 81-84, XP010742234, DOI: 10.1109/CICC.2004.1358740 ISBN: 978-0-7803-8495-8

• KLUGE W ET AL: "A Fully Integrated 2.4GHz IEEE 802.15.4 Compliant Transceiver for ZigBee Applications", DIGEST OF TECHNICAL PAPERS / 2006 IEEE INTERNATIONAL SOLID-STATE CIRCUITS CONFERENCE : SAN FRANCISCO, CA, 5 - 9 FEBRUARY 2006, IEEE SERVICE CENTER, PISCATAWAY, NJ , US, 6 February 2006 (2006-02-06), pages 1470-1479, XP010940541, DOI: 10.1109/ISSCC.2006.1696197 ISBN: 978-1-4244-0079-9

**Beschreibung**

Die vorliegende Erfindung betrifft einen Differenzverstärker und ein Funksystem mit einem Differenzverstärker.

Hochfrequenz-Verstärker werden für eine Vielzahl von Anwendungsfällen benötigt. So dienen Hochfrequenz-Verstärker der Verstärkung von empfangenen oder zu sendenden Radiosignalen. Weiterhin werden Hochfrequenz-Verstärker in Sensorsystemen, in Mobiltelefonen oder Radaranlagen verwendet. Für mehrere Anwendungen ist es dabei ausreichend, dass der Verstärker lediglich ein schmales Frequenzband im Bereich einer Betriebsfrequenz verstärkt. Ein derartiger Verstärker wird auch als Selektivverstärker bezeichnet. Bekannte Verstärkerschaltungen sind beispielsweise der Differenzverstärker.

Ein Differenzverstärker ist beispielsweise in "Analoge Schaltungen"; Seifart; 4. Aufl.; Verlag Technik Berlin; 1994; Seiten 107 ff. offenbart. Die Ausgangsspannung des Differenzverstärkers ist proportional zur Differenzspannung zwischen beiden Eingangsklemmen. Gleichtaktspannungen, die an beiden Eingängen in gleicher Amplitude und Phasenlage wirken, werden vom idealen Differenzverstärker nicht verstärkt. Die vorteilhaften Eigenschaften erhält der Differenzverstärker durch seinen weitgehend symmetrischen Aufbau. Die Emitter der beiden Eingangstransistoren sind dabei üblicherweise miteinander und mit einer Konstantstromquelle verbunden.

Aus GRAMEGNA G et at, "An 8.2-ghz, 14.4mw, 1.6db nf sige bipolar lna with dc current reuse", PROCEEDINGS OF THE 2003 BIPOLAR/BICMOS CIRCUITS AND TECHNOLOGY MEETING. (BCTM), Toulouse, France, Sept. 28-30, 2003, IEEE BIPOLAR/BICMOS CIRUITS AND TECHNOLOGY MEETING, NEW YORK, NY: IEEE, US, 28. SEPTEMBER 2003, Seiten 49-52, ist ein zweistufiger Differenzverstärker offenbart dessen Eingangstransistoren in Emitterschaltung verschaltet sind und eine Miller Neutralisation mittels zweier weiterer Transistoren aufweist. Die zweite Stufe weist zur Verstärkung zwei Transistoren in Emitterschaltung, deren Kollektoren mit einem LC-Schwingkreis verbunden sind.

Aus der US 6,392,486 B1 ist ein Verstärker für drahtlose Kommunikation bekannt. Die MOS-Eingangstransistoren des Verstärkers sind in Gate-Schaltung betrieben. Die Eingangstransistoren sind jeweils mit einer Induktivität als Last verbunden. Jede Induktivität wirkt als Kurzschluss des Gates und des Drains des zugehörigen Transistors für niedrige Frequenzen.

Aus der EP 1 067 679 A2 ist ein Differenzverstärker als integrierter Baustein mit einem Gegentakteingang, einem Gegentaktausgang, zwei Verstärkerstufen und zwei Kaskodestufen bekannt. Die zwei Kaskodestufen sind mit einem Umschalter schaltbar. Mit Transistoren der zweiten Verstärkerstufe ist eine Selektionsschaltung mit einem Schwingkreis mit zwei Spulen und einer Kapazität verbunden.

Aus Che-Hong Liao et al "A 5.7-GHz 0.18-um CMOS Gain-Controlled Differential LNA With Current Reuse for WLAN Receiver", IEEE MICROWAVE AND WIRELESS COMPUENTS LETTERS; VOL. 13, NO. 12, DECEMBER 2003, ist ein zweistufiger Differenzverstärker bekannt. Die MOS-Eingangstransistoren sind in Sourceschaltung verschaltet. Die MOS-Transistoren der zweiten Stufe sind ebenfalls in Sourceschaltung verschaltet.

Aus RAGONESE E ET AL: "A 5-GHz monolithic silicon bipolar down-converter with on-chip image filtering", ELECTROTECHNICAL CONFERENCE, 2004. MELECON 2004, PROCEEDINGS OF THE 12 TH IEEE MEDITERRANEAN DUBROVNIK, CROATIA 12-15 MAY 2004, PISCATAWAY, NJ, USA, IEEE, US, May 12, 2004 (2004-05-12), pages 159-162 Vol. 1, XP010733752, DOI: 10.1109/MELCON. 2004.1346797 ISBN: 978-0-7803-8271-8, ist ein Differenzverstärker bekannt, der eine erste Induktivität, eine zweite Induktivität und eine Kapazität aufweist, wobei die Kapazität, die erste Induktivität une die zweite Induktivität derart zu einem Resonanzkreis verschaltet sind.

Aus GRAMEGNA G ET AL: "23mm 2single_chip 0.18/spl mu/m CMOS GPS receiver with 28 mW-4.1 mm 2radio and CPU/DSP/RAM/ROM", CUSTOM INTEGRATED CIRCUITS CONFERENCE, 2004. PROCEEDINGS OF THE IEEE 2004, IEEE, PISCATAWAY, NJ, USA, October 3, 2004 (2004-10-03), pages 81-84, XP010742234, DOI: 10.1109/CICC.2004.1358740 ISBN: 978-0-7803-8495-8 ist ein GPS Empfänger bekannt, der einen Differenzverstärker mit einem Resonanzlastkreis aufweist.

In IEEE Journal of Solid-State Circuits, VOL. 38, NO. 2, Feb. 2003; Seiten 176 ff. ist ein Niederleistungs - 2,4 GHz - Sender/Empfänger - CMOS IC mit einem Differenzverstärker bekannt Aus IEEE Journal of Solid-State Circuits, VOL. 38, NO. 4, April 2003 ist ein 5,2 GHz Nieder-Rauschen-Verstärker in 0,35 $\mu$m CMOS-Technologie mit einem Differenzverstärker bekannt.

Der Erfindung liegt die Aufgabe zu Grunde, für eine Hochfrequenz einen Differenzverstärker mit möglichst verbesserten elektrischen Eigenschaften weiter zu entwickeln. Diese Aufgabe wird durch einen Differenzverstärker mit den Merkmalen des Anspruchs 1 gelöst Eine weitere Aufgabe besteht darin ein Funksystem mit einem möglichst verbesserten Differenzverstärker zu entwickeln. Diese Aufgabe wird durch ein Funksystem mit den Merkmalen des Anspruchs 14 gelöst. Vorteilhafte Weiterbildungen der Erfindung sind Gegenstand von Unteransprüchen.

Demzufolge ist ein Differenzverstärker vorgesehen, der eine erste Induktivität aufweist, die mit einer zweiten Induktivität magnetisch gekoppelt ist. Weiterhin weist der Differenzverstärker eine Kapazität auf. Die Kapazität, die erste Induktivität und die zweite Induktivität sind derart zu einem Resonanzkreis verschaltet, dass der Resonanzkreis für ein Gleichtaktsignal eine Gleichtakt-Impedanz und für ein Gegentaktsignal eine von der Gleichtakt-Impedanz verschiedene Gegentakt-Impedanz aufweist.

Unter einem Gleichtaktsignal wird dabei ein Signal verstanden, dass an beiden Eingängen des Differenzverstärkers mit gleicher Frequenz und gleicher Phasenlage und gleicher Amplitude anliegt. Unter einem Gegentaktsignal wird ein an den Eingängen anliegendes Signal mit gleicher Frequenz, gleicher Amplitude und einer um 180° verschobenen Phase verstanden. Gleichtaktsignale und Gegentaktsignale können auch einander überlagert sein. Das Gegentaktsignal ist dabei üblicherweise das Nutzsignal. Zur Ausbildung der Resonanz für das Gleichtaktsignal werden bei deren Auslegung vorzugsweise eine effektive Eingangsimpedanz einer nachfolgenden Stufe und/oder beeinflussende parasitäre Impedanzen berücksichtigt. Vorteilhafterweise ist der Differenzverstärker als Selektivverstärker zur Verstärkung von Signalen einer oder mehrerer Betriebsfrequenzen ausgebildet. Vorzugsweise ist dabei die Resonanz des Resonanzkreises auf zumindest eine Betriebsfrequenz, insbesondere 2,4 GHz, abgestimmt. Der Resonanzkreis kann auch als Schwingkreis bezeichnet werden. Vorteilhafterweise sind die erste Induktivität und die zweite Induktivität im Rahmen der Fertigungstoleranzen gleich ausgebildet.

Bevorzugt ist der Differenzverstärker zur Verstärkung von Hochfrequenzsignalen ausgebildet, wobei unter Hochfrequenz ein Bereich verstanden wird, in dem das transiente Verhalten der Transistoren wesentlich durch parasitäre Impedanzen, insbesondere durch den Miller-Effekt beeinflusst wird.

Es sind ein erster Transistor und ein zweiter Transistor vorgesehen, wobei der Resonanzkreis mit dem ersten Transistor und dem zweiten Transistor derart verbunden ist, dass der Resonanzkreis eine insbesondere symmetrische Last für den ersten Transistor und für den zweiten Transistor ausbildet. Vorteilhafterweise sind der erste Transistor und der zweite Transistor im Rahmen der Fertigungstoleranzen gleich ausgebildet (engl. matching). Vorzugsweise ist die Verstärkung durch den ersten Transistor und den zweiten Transistor von der Höhe der Impedanz abhängig.

Der erste Transistor und der zweite Transistor sind in Gateschaltung (dt. auch Torschaltung) verschaltet. Werden anstelle von Feldeffekttransistoren Bipolartransistoren verwendet, sind diese in Basisschaltung verschaltet. In der Gateschaltung sind die Gate-Anschlüsse (dt. auch Tor-Anschluss) mit einer konstanten Spannungsquelle verbunden und somit bezüglich des zu verstärkenden Signals gegen Masse wechselspannungsmäßig kurzgeschlossen. In der Basisschaltung sind die Basen des ersten Transistors und des zweiten Transistors mit einer Konstant-Spannungsquelle verbunden und somit ebenfalls wechselspannungsmäßig nach Masse kurzgeschlossen. Der Resonanzkreis ist in jeder dieser Weiterbildungen die Last der differentiell verschalteten Transistoren.

Ein erster Source-Anschluss (dt. auch Quelle-Anschluss) beziehungsweise ein erster Emitter-Anschluss des ersten Transistors ist mit einem ersten Eingang des Differenzverstärkers und ein zweiter Source-Anschluss beziehungsweise ein zweiter Emitteranschluss des zweiten Transistors ist mit einem zweiten Eingang des Differenzverstärkers verbunden. Bevorzugt sind mit diesen Eingangstransistoren dabei keine Stromquelle oder Stromsenke verbunden.

Gemäß einer bevorzugten Ausgestaltung sind eine Steilheit des ersten Transistors und eine Steilheit des zweiten Transistors zur Bildung einer Eingangsimpedanz des Differenzverstärkers von 50 Ohm ausgebildet. Vorzugsweise sind die Geometrien (Kanalbreite/Kanallänge) und/oder das Dotierprofil an die Anforderungen der Eingangsimpedanz angepasst. Vorteilhafterweise ist der erste Source-Anschluss beziehungsweise der erste Emitter-Anschluss des ersten Transistors und der zweite Source-Anschluss beziehungsweise der zweite Emitteranschluss des zweiten Transistors mit einem weiteren Resonanzkreis des Differenzverstärkers verbunden. Vorzugsweise bildet der weitere Resonanzkreis eine Gleichtakt-Eingangsimpedanz und eine Gegentakt-Eingangsimpedanz, um das Gegentakt-Eingangssignal geringer zu Dämpfen als das Gleichtakt-Eingangssignal.

In einer vorteilhaften Ausgestaltung der Erfindung ist für das Gegentaktsignal die Resonanzfrequenz beider Resonanzkreise im Rahmen der Fertigungstoleranzen gleich (engl. matching).

Bevorzugt sind die erste Induktivität und die zweite Induktivität durch symmetrische Spulenwicklungen gebildet. Der Wickelsinn bestimmt dabei das Vorzeichen der magnetischen Kopplung. Die magnetische Kopplung ist bei einer symmetrischen Spulenwicklung vorzugsweise positiv.

Gemäß einer besonders bevorzugten Ausgestaltung der Erfindung ist vorgesehen, dass die erste Induktivität und die zweite Induktivität durch eine integrierte Spule mit Mittelabgriff gebildet sind.

Um die Erfindung vorteilhaft auszugestalten sind die erste Induktivität und die zweite Induktivität derart magnetisch gekoppelt, dass sich für Gleichtaktsignale das durch einen Laststrom durch die erste Induktivität abfallende Spannungssignal und das induzierte Spannungssignal destruktiv überlagern. Hingegen überlagern sich das durch einen Laststrom durch die erste Induktivität abfallende Spannungssignal und das induzierte Spannungssignal für Gegentaktsignale konstruktiv. Das induzierte Spannungssignal wird dabei durch ein Magnetfeld induziert, das von der zweiten Induktivität erzeugt ist. Dasselbe gilt natürlich auch für den umgekehrten Fall, in dem in der zweiten Induktivität ein Spannungssignal induziert wird.

Gemäß einer vorteilhaften Weiterbildung der Erfindung weist der Differenzverstärker zwei kaskadierte Verstärkerstufen auf. Dabei weist eine erste Verstärkerstufe den ersten Transistor und den zweiten Transistor auf. Eine zweite Verstärkerstufe weist einen dritten Transistor und einen vierten Transistor auf. Vorzugsweise sind die erste Verstärkerstufe und die zweite Verstärkerstufe durch einen identischen Betriebsstrom betrieben, der sowohl durch die erste Verstärkerstufe als auch durch die zweite Verstärkerstufe fließt. Vorteilhafterweise sind der dritte Transistor und der vierte Transistor im Rahmen der Fertigungstoleranzen gleich ausgebildet (engl. matching). Gemäß einer vorteilhaften Weiterbildung ist vorgesehen, dass der dritte Transistor und der vierte Transistor jeweils in Sourceschaltung (dt. auch Quellenschaltung) beziehungsweise in Emitterschaltung verschaltet sind. Bevorzugt ist ein dritter Gate-Anschluss beziehungsweise ein dritter Basis-Anschluss des dritten Transistors über eine erste Koppel-Kapazität mit dem ersten Drain-Anschluss (dt. auch Senken-Anschluss) beziehungsweise mit dem ersten Kollektor-Anschluss des ersten Transistors verbunden. Ebenfalls bevorzugt ist ein vierter Gate-Anschluss beziehungsweise ein vierter Basis-Anschluss des vierten Transistors über eine zweite Koppel-Kapazität mit dem zweiten Drain-Anschluss beziehungsweise mit dem zweiten Kollektor-Anschluss des zweiten Transistors verbunden.

In einer Weiterbildung sind ein fünfter Transistor und eine sechster Transistor vorgesehen. Der fünfte Transistor ist mit dem dritten Transistor zu einer ersten Kaskodestufe verbunden. Der sechste Transistor ist mit dem vierten Transistor zu einer zweiten Kaskodestufe verbunden.

In einer anderen Weiterbildung sind Kapazitäten zur Neutralisation der Millerkapazitäten des dritten Transistors und des vierten Transistors vorgesehen. Bevorzugt sind ein fünfter Transistor und ein sechster Transistor als Kapazitäten zur Neutralisation vorgesehen. Der fünfte Transistor ist mit dem dritten Transistor und dem vierten Transistor zur Neutralisation der Millerkapazität des dritten Transistors verbunden. Der sechste Transistor ist mit dem vierten Transistor und dem dritten Transistor zur Neutralisation der Millerkapazität des vierten Transistors verbunden.

Gemäß einer besonders vorteilhaften Weiterbildung der Erfindung ist ein wiederum weiterer Resonanzkreis als Last der zweiten Verstärkerstufe vorgesehen. Der Resonanzkreis ist mit dem dritten Transistor und dem vierten Transistor verbunden, sofern keine Kaskodestufe verwendet wird. Andernfalls ist der weitere Resonanzkreis mit dem fünften Transistor und dem sechsten Transistor zur Ausbildung der zweiten Verstärkerstufe verbunden.

Die der Erfindung zu Grunde liegende Aufgabe wird weiterhin durch ein Funksystem gelöst. Das Funksystem weist vorzugsweise Sende- und Empfangseinheiten zur Kommunikation auf. Das Funksystem weist einen zuvor erläuterten Differenzverstärker zur Verstärkung einer Übertragungsfrequenz auf. Die Übertragungsfrequenz beträgt vorteilhafterweise 2,4 GHz. Der Differenzverstärker weist vorteilhafterweise eine erste Induktivität, die mit einer zweiten Induktivität magnetisch gekoppelt ist, und eine Kapazität auf.

Die Kapazität, die erste Induktivität und die zweite Induktivität sind vorzugsweise derart zu einem Resonanzkreis verschaltet, dass der Resonanzkreis für ein Gleichtaktsignal der Übertragungsfrequenz eine Gleichtakt-Impedanz aufweist. Weiterhin weist der Resonanzkreis für ein Gegentaktsignal eine von der Gleichtakt-Impedanz verschiedene Gegentakt-Impedanz auf.

Im Folgenden wird die Erfindung in Ausführungsbeispielen anhand von Zeichnungen näher erläutert.

Dabei zeigen

Fig. 1    einen ersten Schaltkreis eines Differenzverstärkers,

Fig. 2    einen zweiten Schaltkreis eines Differenzverstärkers mit zwei Kaskodeanordnungen,

Fig. 3    einen dritten Schaltkreis eines Differenzverstärkers mit einer Neutralisation der Millerkapazitäten, und

Fig. 4    einen vierten Schaltkreis eines Differenzverstärkers mit differentiellen npn-Bipolartransistoren in Emitterschaltung.

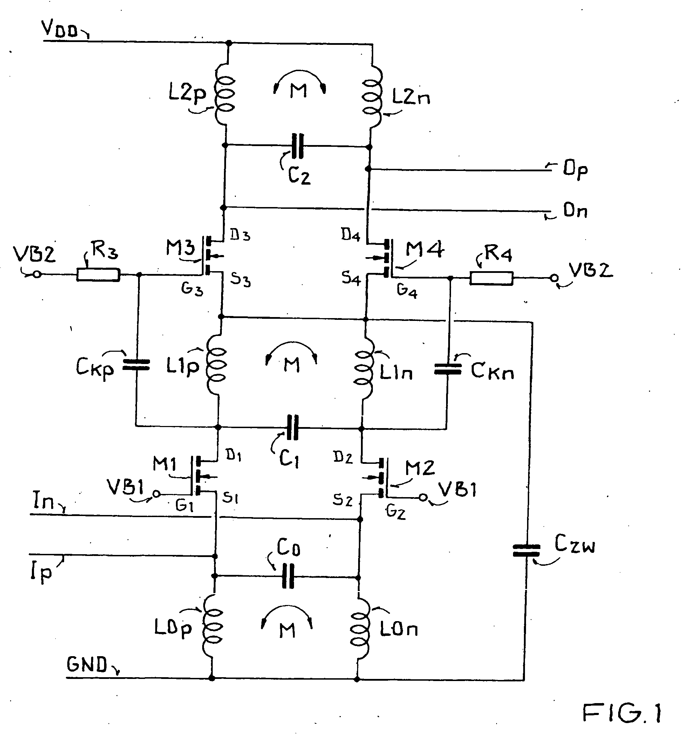

In Fig. 1 ist ein erstes Ausführungsbeispiel eines Differenzverstärkers dargestellt. Der Differenzverstärker der Fig. 1 ist für eine Betriebsfrequenz von vorzugsweise 2,4 GHz ausgelegt. Es ist daher ausreichend, dass der Differenzverstärker als Selektivverstärker ausgebildet ist und einen Frequenzbereich um die Betriebsfrequenz verstärkt. Der Differenzverstärker der Fig. 1 weist einen ersten positiven Eingang $I_p$ und einen zweiten negativen Eingang $I_n$ zur Verstärkung eines Differenzsignals auf.

Der Differenzverstärker der Fig. 1 ist dabei derart ausgebildet, dass ein Gegentaktsignal an den Eingängen $I_n$ und $I_p$ signifikant höher verstärkt wird als ein an den Eingängen $I_n$ und $I_p$ anliegendes Gleichtaktsignal. Das Verhältnis der Verstärkung des Gegentaktsignals zu der Verstärkung des Gleichtaktsignals wird auch als Gleichtaktunterdrückung bezeichnet. Diese Gleichtaktunterdrückung wird für den differentiellen Eingang In $I_p$ gefordert, um eine Unterdrückung von Störungen zu erreichen, die als Schaltrauschen im Digitalteil einer integrierten Schaltung entstehen können.

Der Differenzverstärker der Fig. 1 weist eine erste Verstärkerstufe und eine zweite Verstärkerstufe auf, die kaskadiert sind. Die erste Verstärkerstufe weist einen ersten N-Kanal-Feldeffekttransistor M1, der mit dem positiven Eingang $I_p$ verbunden ist, und einen zweiten N-Kanal-Feldeffekttransistor M2 auf, der mit dem negativen Eingang $I_n$ verbunden ist, auf. Der erste Transistor M1 und der zweite Transistor M2 sind in Gate-Schaltung verschaltet, wobei das erste Gate G1 des ersten Transistors M1 und das zweite Gate G2 des zweiten Transistors M2 auf einem im Wesentlichen konstanten Spannungspotential $V_{B1}$ liegen.

Die Gate-Schaltung der Fig. 1 weist den Vorteil auf, dass eine Eingangskapazität gegenüber einer Source-Schaltung signifikant verringert ist, da bei gegebener Transistorweite die Source-Kapazität kleiner ist als die Gate-Kapazität. Weiterhin ist der Source-Anschluss S1, S2 gegenüber einer elektrostatischen Entladung wesentlich robuster als der Gate-Anschluss G1, G2 desselben Transistors M1, M2. Ein weiterer Vorteil der Schaltung in Fig. 1 ist der, dass der gewünschte Eingangswiderstand von beispielsweise 50 Ohm einfach eingestellt werden kann. Der Eingangswiderstand ist dabei umgekehrt proportional zur Steilheit des Transistors M1, M2. Durch Dotierstoffprofile und die Geometrie (Länge, Breite) des Transistors M1, M2 kann dessen Steilheit applikationsspezifisch eingestellt werden.

Ein erster Drain-Anschluss D1 des ersten Transistor M1 ist mit einem Resonanzkreis verbunden. Ein zweiter Drain-Anschluss D2 des zweiten Transistor M2 ist ebenfalls mit dem Resonanzkreis verbunden. Der Resonanzkreis ist dabei als Last für den ersten Transistor M1 und den zweiten Transistor M2 verschaltet. Der Resonanzkreis weist eine erste Induktivität $L_{1p}$ und eine zweite Induktivität $L_{1n}$ auf, die über eine magnetische Kopplung M miteinander wirkverbunden sind.

Die erste Induktivität $L_{1p}$ ist mit dem ersten Drain-Anschluss D1 des ersten Transistors M1 verbunden. Die zweite Induktivität $L_{1n}$ ist mit dem zweiten Drain-Anschluss D2 des zweiten Transistors M2 verbinden. Weiterhin sind die erste Induktivität $L_{1p}$ und die zweite Induktivität $L_{1n}$ mit einem Kondensator $C_{zw}$ verbunden, der die elektrische Verbindung der beiden Induktivitäten $L_{1p}$, $L_{1n}$ nach Masse GND bezüglich der Betriebsfrequenz kurzschließt. Weiterhin weist der Resonanzkreis eine Kapazität $C_1$ auf, der zum einen mit dem ersten Drain-Anschluss D1 des ersten Transistors M1 und der ersten Induktivität $L_{1p}$ und zum anderen mit dem zweiten Drain-Anschluss D2 des zweiten Transistors M2 und der zweiten Induktivität $L_{1n}$ verbunden ist. Die magnetisch gekoppelten Induktivitäten $L_{1p}$, $U_{1n}$ sind beispielsweise als integrierte Spule mit Mittelabgriff ausgebildet. Zur Integration dieser Spulen können Verdrahtungsebenen eines Chips verwendet werden, wobei innerhalb der Spulenwicklungen ein Isolator ($SiO_2$ oder dergleichen) mit einer relativen Permeabilität von 1 verwendet wird. Die Kapazität $C_1$ ist beispielsweise als integrierter Plattenkondensator ausgebildet.

Die Resonanz des Resonanzkreises $L_{1p}$, $L_{1n}$. $C_1$ ist unter Einbeziehung weiterer angeschlossener Impedanzen, wie beispielsweise die Kapazitäten $C_{Kp}$ und $C_{Kn}$, auf ein an den Eingängen $I_n$ und $I_p$ anliegendes, die Betriebsfrequenz aufweisendes Gegentakt-Eingangssignal derart abgestimmt, dass der Resonanzkreis $L_{1p}$, $L_{1n}$, $C_1$ für das Gegentakt-Eingangssignal auf der Betriebsfrequenz in oder nahe der Resonanz ein Impedanzmaximum aufweist. Für das Impedanzmaximum erreicht die erste Verstärkerstufe mit den Transistoren M1 und M2 in Basisschaltung ein Verstärkungsmaximum.

Dagegen ist der Resonanzkreis $L_{1p}$, $L_{1n}$, $C_1$ für Gleichtaktsignale derart abgestimmt, dass die Impedanz des Resonanzkreises $L_{1p}$, $L_{1n}$, $C_1$ für diese Signale signifikant geringer ist als das Impedanzmaximum für Gegentaktsignale der Betriebsfrequenz. Die unterschiedlichen Impedanzen für Gegentakt- und Gleichtaktsignale werden zum einen dadurch bewirkt, dass die Kapazität C1 für Gleichtaktsignale wirkungslos ist. Weiterhin bewirkt die induktive Kopplung M der ersten Induktivität $L_{1p}$ mit der zweiten Induktivität $L_{1n}$ dass sich die Gleichtaktsignale in jeder Induktivität $L_{1p}$, $L_{1n}$ destruktiv überlagern und somit die resonanzbestimmenden Induktivitäten $L_{1p}$, $L_{1n}$ entsprechend reduziert wirken. Die Kopplung M ist vorzugsweise derart ausgebildet sein, dass im Gegentaktbetrieb die Gesamtinduktivität im Resonanzkreis um den zweifachen Wert der induktiven Kopplung M erhöht ist.

Im Gegentaktbetrieb ist die Gesamtinduktivität

$$L = L_{1p} + L_{1n} + 2M$$

und im Gleichtaktbetrieb

$$L = L_{1p} + L_{1n} - 2M.$$

Die geringere Gesamtinduktivität im Gleichtaktbetrieb führt zu einer höheren Resonanzfrequenz des Lastschwingkreises $L_{1p}$, $L_{1n}$, $C_1$ und damit zu einer geringeren Verstärkung bei der Betriebsfrequenz, auf die der Resonanzkreis $L_{1p}$, $L_{1n}$, $C_1$ bei Gegentaktbetrieb abgestimmt ist. Bei geringen Spulengüten von 5 bis 6, die für integrierte Induktivitäten $L_{1p}$ und $L_{1n}$ erzielbar sind, lassen sich durch den Schaltungsaufbau der Fig. 1 Gleichtaktunterdrückungen von 15dB bis 20dB pro Verstärkerstufe erreichen.

Die Schaltung der Fig. 1 weist zudem den Vorteil auf, dass auf eine Stromquelle an den Source-Anschlüssen S1 und S2 des ersten Transistors M1 und des zweiten Transistors M2 verzichtet werden kann. Eine derartige Stromquelle würde einen zusätzlichen Spannungsabfall benötigen, der den Verstärkerstufen verloren geht und damit den maximalen Spannungshub reduziert. Anstelle einer Stromquelle sind die Transistoren M1 und M2 in Source-Schaltung verschaltet.

Parallel zu den Eingängen ist ein weiterer Resonanzkreis $L_{0p}$, $L_{0n}$, $C_0$ gegen Masse GND geschaltet. Wiederum sind zwei magnetisch gekoppelte Induktivitäten $L_{0p}$ und $L_{0n}$ vorgesehen, wobei die erste Induktivität $L_{0p}$ mit Masse GND und mit dem ersten Source-Anschluss S1 des ersten Transistors M1 verbunden ist. Die zweite Induktivität $L_{0n}$ ist mit Masse GND und mit dem zweiten Source-Anschluss S2 des zweiten Transistors M2 verbunden. Wiederum bildet dieser Resonanzkreis ein Impedanzmaximum für Gegentaktsignale für die Betriebsfrequenz aus. Durch die Parallelschaltung der Eingangsimpedanz von 50 Ohm des ersten Transistors M1 und des zweiten Transistors M2 ist die Gesamt-Eingangsimpedanz des Differenzverstärkers der Fig. 1 jedoch auf diese 50 Ohm begrenzt. Für Gleichtaktsignale der Betriebsfrequenz kann die Gesamt-Eingangsimpedanz entsprechend den obigen Ausführungen zur Lastimpedanz niedriger sein.

Die Schaltung der Fig. 1 ist als kaskadierte Anordnung von zwei Verstärkerstufen ausgebildet. Beide Verstärkerstufen nutzen dabei denselben Ruhestrom zur Arbeitspunkteinstellung. Die Summe der Gleichströme, die durch den ersten Transistor M1 und durch den zweiten Transistor M2 fließt, entspricht dabei der Summe der Gleichströme, die durch den dritten Transistor M3 und den vierten Transistor M4 fließen. Durch einen Kondensator $C_{zw}$ sind beide Stufen bezüglich der Betriebfrequenz entkoppelt, da dieser Kondensator $C_{zw}$ für die Betriebsfrequenz einen Wechselspannungs-Kurzschluss nach Masse GND darstellt. Für konstante Arbeitspunktströme fällt über diesen Kondensator $C_{zw}$ daher eine im Wesentlichen konstante Zwischen-Spannung ab.

Der differentielle Ausgang der ersten Verstärkerstufe ist mit dem differentiellen Eingang der zweiten Verstärkerstufe aus den Transistoren M3 und M4 über zwei integrierte Koppelkondensatoren $C_{Kp}$ und $C_{Kn}$ wechselspannungsmäßig gekoppelt. Der dritte Transistor M3 und der vierte Transistor M4 sind in Source-Schaltung verschaltet. Das dritte Gate G3 des dritten Transistors M3 ist über einen hochohmigen Widerstand R3 mit einer Konstantspannungsquelle $V_{B2}$ zur Arbeitspunkteinstellung und mit dem Kondensator $C_{Kp}$ zur Einkopplung des Wechselspannungs-Signals verbunden. Das vierte Gate G4 des vierten Transistors M4 ist über einen hochohmigen Widerstand R4 mit derselben Konstantspannungsquelle $V_{B2}$ zur Arbeitspunkteinstellung und mit dem Kondensator $C_{Kn}$ zur Einkopplung des Wechselspannungs-Signals verbunden.

An dem dritten Drain-Anschluss D3 des dritten Transistors M3 und an dem vierten Drain-Anschluss D4 des vierten Transistors M4 ist wiederum ein weiterer Resonanzkreis $L_{2p}$, $L_{2n}$, $C_2$ als Last angeschlossen. Weiterhin ist an dem dritten Drain-Anschluss D3 des dritten Transistors M3 der negative Ausgang $O_n$ des Differenzverstärkers und an dem vierten Drain-Anschluss D4 des vierten Transistors M4 der positive Ausgang Op des Differenzverstärkers angeschlossen.

Der weitere Resonanzkreis $L_{2p}$, $L_{2n}$, $C_2$ der zweiten Verstärkerstufe wirkt als Last analog dem Lastschwingkreis $L_{1p}$, $L_{1n}$, $C_1$ der ersten Verstärkerstufe. Für Gegentaktsignale der Betriebsfrequenz weist der weitere Resonanzkreis $L_{2p}$, $L_{2n}$, $C_2$ in seiner Resonanz ein Impedanzmaximum auf, so dass die Verstärkung der zweiten Verstärkungsstufe für Gegentaktsignale maximiert ist. Hingegen ist für Gleichtaktsignale die Impedanz signifikant kleiner und somit auch die Verstärkung dieser Gleichtaktsignale. Durch beide Verstärkerstufen kann somit eine Gleichtaktunterdrückung von 30dB bis 40dB erzielt werden.

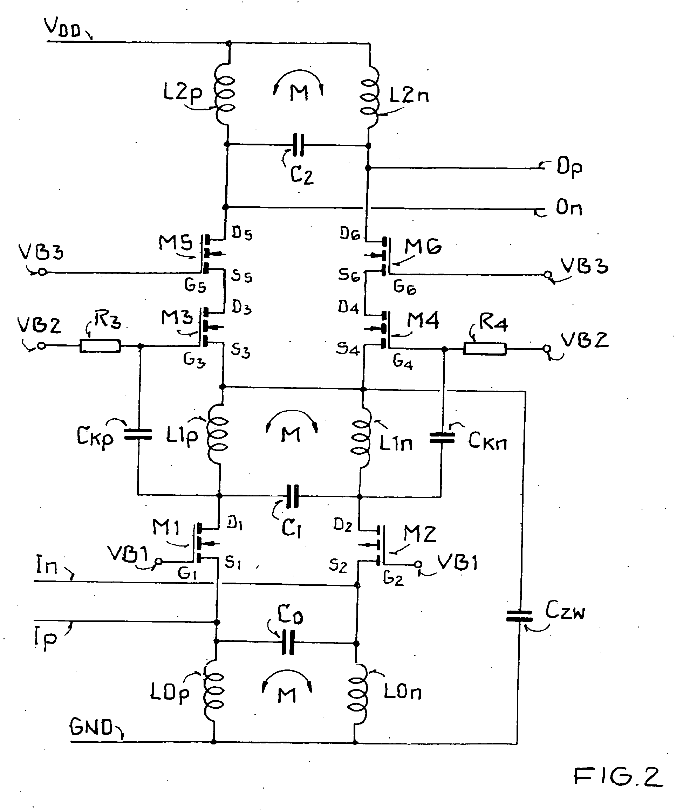

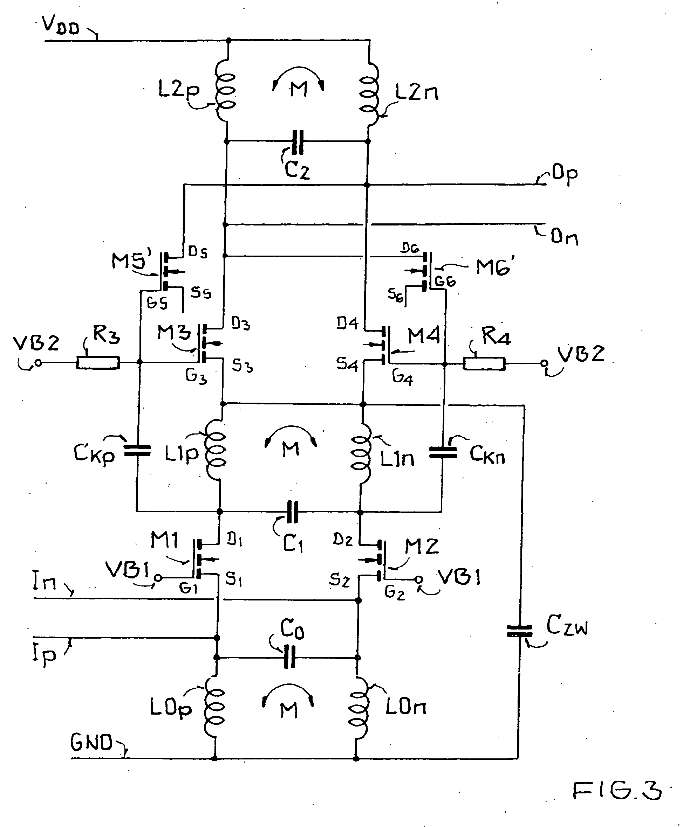

Um gegebenenfalls Rückwirkungen der Miller-Kapazität des dritten Transistors M3 und des vierten Transistors M4 zu reduzierten, sind in den Figuren 2 und 3 andere Ausführungsbeispiele der Erfindung dargestellt, die den Miller-Effekt größtenteils kompensieren.

Fig. 2 zeigt eine zweite Verstärkerstufe, die zusätzliche zu dem dritten Transistor M3 und dem vierten Transistor M4 einen fünften Transistor M5 und einen sechsten Transistor M6 aufweist. Der fünfte Transistor M5 ist mit dem dritten Transistor M3 zu einer ersten Kaskodeanordnung verschaltet. Der vierte Transistor M4 ist mit dem sechsten Transistor M6 zu einer zweiten Kaskodeanordnung verschaltet. Die Gate-Anschlüsse G5 und G6 des fünften Transistors M5 und des sechsten Transistors M6 sind an eine Konstant-Spannungsquelle $V_{B2}$ angeschlossen.

Die Drain-Anschlüsse D5 und D6 des fünften Transistors M5 und des sechsten Transistors M6 sind mit dem weiteren Resonanzkreis $L_{2p}$, $L_{2n}$, $C_2$ und den Ausgängen Op und $O_n$ verbunden. Zusätzlich zur Verhinderung des Miller-Effektes hat die Kaskodeanordnung den Vorteil inne, dass eine größere Verstärkung durch die zweite Stufe erzielbar ist. Weiterhin müssen lediglich die Transistoren M5 und M6 für den Ausgangsspannungshub die notwendige Durchbruchspannungsfestigkeit aufweisen.

Ein drittes Ausführungsbeispiel ist in Fig. 3 dargestellt. Die zweite Verstärkerstufe weist zusätzlich zu dem dritten Transistor M3 und dem vierten Transistor M4 in Emitterschaltung die Transistoren M5' und M6' auf. Die Transistoren M5' und M6' sind in einer Neutralisierungsschaltung (engl. cross quad) zur Neutralisierung der Miller-Kapazitäten verschaltet. Zur Neutralisation der Miller-Kapazität des vierten Transistors M4 ist der sechste Gate-Anschluss G6 des sechsten Transistors M6' mit dem vierten Gate-Anschluss G4 des vierten Transistors M4 verbunden. Weiterhin ist der sechste Drain-Anschluss D6 des sechsten Transistors M6' mit dem dritten Drain-Anschluss D3 des dritten Transistors M3 verbunden. Zur Neutralisation der Miller-Kapazität des dritten Transistors M3 ist der der fünfte Gate-Anschluss G5 des fünften Transistors M5' mit dem dritten Gate-Anschluss G3 des dritten Transistors M3 verbunden. Weiterhin ist der fünfte Drain-Anschluss D5 des fünften Transistors M5' mit dem vierten Drain-Anschluss D4 des vierten Transistors M4 verbunden. Die Source-Anschlüsse S5 und S6 sind nicht verbunden.

Die Ausführungsvariante aus Fig. 3 hat gegenüber der Ausführungsvariante der Fig. 2 den Vorteil, dass im Arbeitspunkt die über die zweite Verstärkerstufe abfallende Gleichspannung geringer ist, so dass ein größerer Ausgangshub bei kleinen Versorgungsspannungen $V_{DD}$ zur Verfügung steht. Weiterhin weist das Ausführungsbeispiel gegenüber einer Kaskodeschaltung eine verbesserte Stabilität auf.

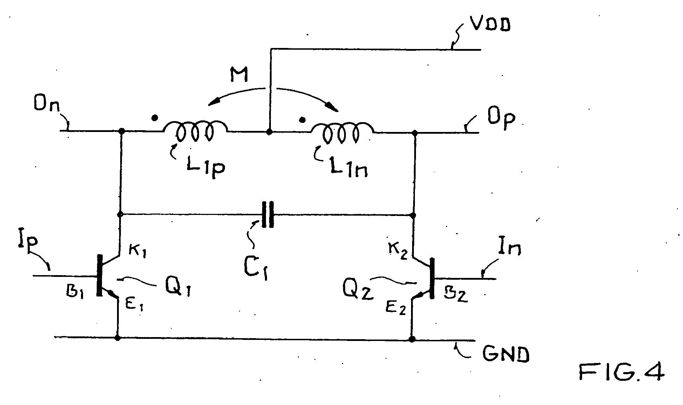

Eine nicht beanspruchte Schaltung ist in Fig. 4 dargestellt. Eine erste Basis B1 eines ersten npn-Bipolartransistor Q1 ist mit einem Eingang $I_p$ des Differenzverstärkers verbunden. Eine zweite Basis B2 eines zweiten npn-Bipolartransistor Q2 ist mit einem weiteren Eingang $I_n$ des Differenzverstärkers verbunden. Der erste npn-Bipolartransistor $Q_1$ und der zweite npn-Bipolartransistor sind differentiell in Emitter-Schaltung verschaltet. Die Kollektoren K1 und K2 der beiden npn-Bipolartransistoren Q1 und Q2 sind mit einem Resonanzkreis aus einer Kapazität C1 und einer Spule mit Mittelabgriff gebildet, deren erste Induktivität L1 p mit der zweiten Induktivität L1n über den Koppelfaktor M gekoppelt ist. Der Wickelsinn beider Spulenteile ist, wie in Fig. 4 dargestellt, gleich. Die Ausgänge $O_n$ und Op des einstufigen Differenzverstärkers sind mit den Kollektoren K1 beziehungsweise K2 der npn-Bipolartransistoren Q1 beziehungsweise Q2 verbunden. Diese Schaltung weist die Vorteile eine höheren Eingangsimpedanz und einer sehr geringen Versorgungsspannung auf. Bauelemente zur Arbeitspunkteinstellung sind in Fig. 4 zu Gunsten einer vereinfachten Darstellung fortgelassen.

Alternativ zu den in den Figuren 1 bis 3 dargestellten Ausführungsbeispielen können auch P-Kanal-Feldeffekttransistoren verwendet werden. Ebenfalls ist eine gemischte Verwendung von N-Kanal-Feldeffekttransistoren und P-Kanal-Feldeffekttransistoren vorteilhaft, um beispielsweise das niedrigere Transistorrauschen eines P-Kanal-Feldeffekttransistors in der Eingangs-Verstärkerstufe zu verwenden. Ebenfalls vorteilhaft ist eine gemischte Verwendung von Feldeffekttransistoren und Bipolartransistoren in ein und demselben Differenzverstärker. Demnach können eine differentielle Gate-Schaltung, eine differentielle Basis-Schaltung, eine differentielle Source-Schaltung, eine differentielle Emitter-Schaltung, eine differentielle Drain-Schaltung und/oder eine differentielle Kollektorschaltung in Kombination verschiedener Verstärkergrundschaltungen verschaltet sein. Entsprechend des Typus der verschalteten differentiellen Verstärkergrundschaltung kann der Frequenzgang des Differenzverstärkers der Applikation angepasst werden.

<div align="center">Bezugszeichenliste</div>

| | |
|---|---|
| M1, M2, M3, M4, M5, M6, M5', M6' | N-MOSFET |
| Q1, Q2 | npn-Bipolartransistor |
| $C_0$, $C_1$, $C_2$, $C_{Kp}$, $C_{Kn}$, $C_{zw}$ | Kapazität, Kondensator |
| R3, R4 | Widerstand |
| L0p und L1n, L1p und L1n, L2p und L2n | magnetisch gekoppelte Induktivitäten |
| M | magnetische Kopplung |
| $V_{DD}$ | Versorgungsspannung |
| GND | Masse |
| $V_{B1}$, $V_{B2}$, $V_{B3}$ | Konstantspannung |
| $I_n$ | negativer Eingang |
| $I_p$ | positiver Eingang |
| $O_n$ | negativer Ausgang |
| $O_p$ | positiver Ausgang |

**Patentansprüche**

1. Differenzverstärker

   - mit einer ersten Induktivität (L1p), und einer zweiten Induktivität (L1n), und
   - mit einer Kapazität (C1),
   - bei dem die Kapazität (C1), die erste Induktivität (L1p) und die zweite Induktivität (L1n) derart zu einem Resonanzkreis (C1, L1p, L1n) verschaltet sind, dass der Resonanzkreis (C1, L1p, L1n) für ein Gleichtaktsignal eine Gleichtakt-Impedanz und für ein Gegentaktsignal eine von der Gleichtakt-Impedanz verschiedene Gegentakt-Impedanz aufweist,
   - bei dem ein erster Transistor (M1) und ein zweiter Transistor (M2) in Gateschaltung beziehungsweise Basisschaltung zur Verstärkung in einem Frequenzbereich um eine Betriebsfrequenz verschaltet sind,
   - bei dem der Resonanzkreis (C1, L1p, L1n) mit dem ersten Transistor (M1) und dem zweiten Transistor (M2) derart verbunden ist, dass der Resonanzkreis (C1, L1p, L1n) eine symmetrische Last für den ersten Transistor (M 1) und für den zweiten Transistor (M2) ausbildet,
   - bei dem ein erster Source-Anschluss (S1) beziehungsweise ein erster Emitter-Anschluss des ersten Transistors (M1) mit einem ersten Eingang (Ip) des Differenzverstärkers und bei dem ein zweiter Source-Anschluss (S2) beziehungsweise ein zweiter Emitteranschluss des zweiten Transistors (M2) mit einem zweiten Eingang ($I_n$) des Differenzverstärkers verbunden sind

**dadurch gekennzeichnet, dass**

die erste Induktivität und die zweite Induktivität derart magnetisch gekoppelt sind, dass sich für Gleichtaktsignale das durch einen Laststrom durch die erste Induktivität abfallende Spannungssignal und das durch das von der zweiten Induktivität erzeugte Magnetfeld bewirkte induzierte Spannungssignal destruktiv und für Gegentaktsignale konstruktiv überlagern, so dass zur Gleichtautunterdrückung für die Betriebsfrequenz die Gleichtakt-Impedanz geringer als die Gegentakt-Impedanz ist.

2. Differenzverstärker nach Anspruch 1, bei dem eine Steilheit des ersten Transistors (M1) und eine Steilheit des zweiten Transistors (M2) im Rahmen der Fertigungstoleranzen zur Bildung einer Eingangsimpedanz des Differenzverstärkers von 50 Ohm ausgebildet sind.

3. Differenzverstärker nach einem der vorhergehenden Ansprüche, bei dem ein erster Source-Anschluss (S1) beziehungsweise ein erster Emitter-Anschluss des ersten Transistors (M1) und ein zweiter Source-Anschluss (S2) beziehungsweise ein zweiter Emitteranschluss des zweiten Transistors (M2) mit einem weiteren Resonanzkreis (C1, L1p, L1n) des Differenzverstärkers verbunden sind.

4. Differenzverstärker nach Anspruch 3, bei dem für das Gegentaktsignal die Resonanzfrequenz beider Resonanzkreise ([C0, L0p, L0n], [C1, L1p, L1n]) im Rahmen der Fertigungstoleranzen gleich ist.

5. Differenzverstärker nach einem der vorhergehenden Ansprüche, bei dem die erste Induktivität (L0p, L1 p, L2p) und die zweite Induktivität (L0n, L1n, L2n) durch symmetrische Spulenwicklungen gebildet sind.

6. Differenzverstärker nach einem der vorhergehenden Ansprüche, bei dem die erste Induktivität (L0p, L1 p, L2p) und die zweite Induktivität (L0n, L1n, L2n) durch eine integrierte Spule mit Mittelabgriff gebildet sind.

7. Differenzverstärker nach einem der vorhergehenden Ansprüche, der als Selektivverstärker zur Verstärkung einer Betriebsfrequenz ausgebildet ist, wobei eine Resonanz des Resonanzkreises ([C0, L0p, L0n], [C1, L1 p, L1n], [C2, L2p, L2n]) im Rahmen der Fertigungstoleranzen der Betriebsfrequenz von 2,4 GHz entspricht.

8. Differenzverstärker nach einem der vorhergehenden Ansprüche, mit zwei kaskadierten Verstärkerstufen,

   - bei dem die erste Verstärkerstufe den ersten Transistor (M1) und den zweiten Transistor (M2) aufweist,
   - bei dem die zweite Verstärkerstufe einen dritten Transistor (M3) und einen vierten Transistor (M4) aufweist,
   - bei dem die erste Verstärkerstufe und die zweite Verstärkerstufe durch einen identischen Betriebsstrom betrieben sind, der sowohl durch die erste Verstärkerstufe als auch durch die zweite Verstärkerstufe fließt.

9. Differenzverstärker nach Anspruch 8,

   - bei dem der dritte Transistor (M3) und der vierte Transistor (M4) jeweils in Sourceschaltung beziehungsweise in Emitterschaltung verschaltet sind,
   - bei dem ein dritter Gate-Anschluss (G3) beziehungsweise ein dritter Basis-Anschluss des dritten Transistors (M3) über eine erste Koppel-Kapazität (CKp) mit dem ersten Drain-Anschluss (D1) beziehungsweise mit dem ersten Kollektor-Anschluss des ersten Transistors (M1) verbunden ist, und
   - bei dem ein vierter Gate-Anschluss (G4) beziehungsweise ein vierter Basis-Anschluss des vierten Transistors (M4) über eine zweite Koppel-Kapazität (CKn) mit dem zweiten Drain-Anschluss (D2) beziehungsweise mit dem zweiten Kollektor-Anschluss des zweiten Transistors (M2) verbunden ist.

10. Differenzverstärker nach einem der Ansprüche 8 oder 9,

   - mit einem fünften Transistor (M5), der mit dem dritten Transistor (M3) zu einer ersten Kaskodestufe verbunden ist,
   - mit einem sechsten Transistor (M6), der mit dem vierten Transistor (M4) zu einer zweiten Kaskodestufe verbunden ist.

11. Differenzverstärker nach einem der Ansprüche 8 oder 9,

   - mit einer ersten Neutralisations-Kapazität (M5'), die mit dem dritten Transistor (M3) und dem vierten Transistor (M4) zur Neutralisation der Millerkapazität des dritten Transistors (M3) verbunden ist, und

- mit einer zweiten Neutralisations-Kapazität (M6'), die mit dem vierten Transistor (M4) und dem dritten Transistor (M3) zur Neutralisation der Millerkapazität des vierten Transistors (M4) verbunden ist.

12. Differenzverstärker nach Anspruch 11, bei der

- die erste Neutralisations-Kapazität durch einen fünften Transistor (M5') und
- die zweite Neutralisations-Kapazität durch einen sechsten Transistor (M6') gebildet ist.

13. Differenzverstärker nach einem der Ansprüche 8 bis 11, mit einem wiederum weiteren Resonanzkreis (C2, L2p, L2n) als Last der zweiten Verstärkerstufe, wobei der Resonanzkreis (C2, L2p, L2n) mit dem dritten Transistor (M3) und dem vierten Transistor (M4) oder mit dem fünften Transistor (M5) und dem sechsten Transistor (M6) zur Ausbildung der zweiten Verstärkerstufe verbunden ist.

14. Funksystem zur Kommunikation, das einen Differenzverstärker nach einem der vorhergehende Ansprüche zur Verstärkung einer Übertragungsfrequenz von 2,4 GHz aufweist.

**Claims**

1. A differential amplifier

- with a first inductor (L1p) and a second inductor (L1n), and
- with a capacitor (C1),
- in which the capacitor (C1), the first inductor (L1p) and the second inductor (L1n) are connected in a resonance circuit (C1, L1p, L1n) in such a way that the resonance circuit (C1, L1p, L1n) has a common-mode impedance for a common-mode signal and a differential-mode impedance different from the common-mode impedance for a differential-mode signal,
- in which a first transistor (M1) and a second transistor (M2) are connected in a gate circuit or base circuit for amplification in a frequency range around an operating frequency,
- in which the resonance circuit (C1, L1p, L1n) is connected to the first transistor (M1) and the second transistor (M2) in such a way that the resonance circuit (C1, L1p, L1n) forms a symmetrical load for the first transistor (M1) and for the second transistor (M2),
- in which a first source terminal (S1) or a first emitter terminal of the first transistor (M1) is connected to a first input (Ip) of the differential amplifier and in which a second source terminal (S2) or a second emitter terminal of the second transistor (M2) is connected to a second input (In) of the differential amplifier,

**characterized in that**
the first inductor and the second inductor are coupled magnetically in such a way that the voltage signal decreasing by a load current through the first inductor and the induced voltage signal produced by the magnetic field generated by the second inductor are superimposed in a destructive manner for common-mode signals and in a constructive manner for differential-mode signals, so that for the common-mode rejection for the operating frequency the common-mode impedance is lower than the differential-mode impedance.

2. A differential amplifier according to Claim 1, in which a transconductance of the first transistor (M1) and a transconductance of the second transistor (M2) are designed within the scope of manufacturing tolerances in order to form an input impedance of the differential amplifier of 50 $\Omega$.

3. A differential amplifier according to any one of the preceding Claims, in which a first source terminal (S1) or a first emitter terminal of the first transistor (M1) and a second source terminal (S2) or a second emitter terminal of the second transistor (M2) are connected to a further resonance circuit (C1, L1p, L1n) of the differential amplifier.

4. A differential amplifier according to Claim 3, in which the resonance frequency of the two resonance circuits ([C0, L0p, L0n], [C1, L1p, L1n]) is the same within the scope of manufacturing tolerances for the differential-mode signal.

5. A differential amplifier according to any one of the preceding Claims, in which the first inductor (L0p, L1p, L2p) and the second inductor (L0n, L1n, L2n) are formed by symmetrical coil windings.

6. A differential amplifier according to any one of the preceding Claims, in which the first inductor (L0p, L1p, L2p) and the second inductor (L0n, L1n, L2n) are formed by an integrated coil with a centre tap.

7. A differential amplifier according to any one of the preceding Claims, which is designed in the form of a selective amplifier in order to amplify an operating frequency, wherein a resonance of the resonance circuit ([C0, L0p, L0n], [C1, L1p, L1n], [C2, L2p, L2n]) corresponds within the scope of manufacturing tolerances to the operating frequency of 2.4 GHz.

8. A differential amplifier according to any one of the preceding Claims, with two cascaded amplifier stages,

   - in which the first amplifier stage has the first transistor (M1) and the second transistor (M2),
   - in which the second amplifier stage has a third transistor (M3) and a fourth transistor (M4),
   - in which the first amplifier stage and the second amplifier stage are operated by an identical operating current which flow both through the first amplifier stage and through the second amplifier stage.

9. A differential amplifier according to Claim 8,

   - in which the third transistor (M3) and the fourth transistor (M4) are in each case connected in a source circuit or in an emitter circuit,
   - in which a third gate terminal (G3) or a third base terminal of the third transistor (M3) is connected by way of a first coupling capacitor (CKp) to the first drain terminal (D1) or to the first collector terminal of the first transistor (M1), and
   - in which a fourth gate terminal (G4) or a fourth base terminal of the fourth transistor (M4) is connected by way of a second coupling capacitor (CKn) to the second drain terminal (D2) or to the second collector terminal of the second transistor (M2).

10. A differential amplifier according to one of Claims 8 or 9,

    - with a fifth transistor (M5) which is connected to the third transistor (M3) to form a first cascode stage,
    - with a sixth transistor (M6) which is connected to the fourth transistor (M4) to form a second cascode stage.

11. A differential amplifier according to one of Claims 8 or 9,

    - with a first neutralization capacitor (M5') which is connected to the third transistor (M3) and the fourth transistor (M4) in order to neutralize the Miller capacitance of the third transistor (M3), and
    - with a second neutralization capacitor (M6') which is connected to the fourth transistor (M4) and the third transistor (M3) in order to neutralize the Miller capacitance of the fourth transistor (M4).

12. A differential amplifier according to Claim 11, in which

    - the first neutralization capacitor is formed by a fifth transistor (M5'), and
    - the second neutralization capacitor is formed by a sixth transistor (M6').

13. A differential amplifier according to any one of Claims 8 to 11, with in turn a further resonance circuit (C2, L2p, L2n) in the form of a load of the second amplifier stage, wherein the resonance circuit (C2, L2p, L2n) is connected to the third transistor (M3) and the fourth transistor (M4) or to the fifth transistor (M5) and the sixth transistor (M6) to form the second amplifier stage.

14. A radio system for communication, which has a differential amplifier according to any one of the preceding Claims for the amplification of a transmission frequency of 2.4 GHz.

**Revendications**

1. Amplificateur différentiel

   - comprenant un premier inducteur (L1p), et un second inducteur (L1n), et
   - un condensateur (C1),
   - dans lequel le condensateur (C1), le premier inducteur (L1p) et le second inducteur (L1n) sont connectés en un circuit résonnant (C1, L1p, L1n), de sorte que le circuit résonnant (C1, L1p, L1n) présente une impédance en mode commun pour un signal en mode commun et une impédance symétrique pour un signal en mode symétrique qui est différente de l'impédance en mode commun,

- dans lequel un premier transistor (M1) et un second transistor (M2) sont montés respectivement en grille commune ou en base commune afin d'amplifier une fréquence de fonctionnement dans une gamme de fréquences,
- dans lequel le circuit résonnant (C1, L1p, L1n) est connecté au premier transistor (M1) et au second transistor (M2) de sorte que le circuit résonnant (C1, L1p, L1n) forme une charge symétrique pour le premier transistor (M1) et le second transistor (M2),
- dans lequel respectivement une première borne de source (S1) ou une première borne d'émission du premier transistor (M1) est connectée à une première entrée (lp) de l'amplificateur différentiel, et dans lequel respectivement une seconde borne de source (S2) ou une seconde borne d'émission du second transistor (M2) est connectée à une seconde entrée (ln) de l'amplificateur différentiel,

**caractérisé en ce que**,
le premier inducteur et le second inducteur sont magnétiquement couplés, afin que le signal de tension descendent causé par un courant de charge à travers du premier inducteur et que le signal de tension induit par le champ magnétique généré par le second inducteur soient surimposés de manière destructrice pour les signaux en mode commun et de manière constructrice pour les signaux en mode symétrique, de sorte qu'une réjection de mode commun pour la fréquence de fonctionnement de l'impédance en mode commun soit moindre que l'impédance symétrique.

2. Amplificateur différentiel selon la revendication 1, dans lequel une transconductance du premier transistor (M1) et une transconductance du second transistor (M2) sont conçues afin de former une impédance d'entrée de l'amplificateur différentiel d'une valeur de 50 ohms compte tenue des tolérances de fabrication.

3. Amplificateur différentiel selon l'une quelconque des revendications précédentes, dans lequel respectivement une première borne de source (S1) ou une première borne d'émission du premier transistor (M1) et respectivement une seconde borne de source (S2) ou une seconde borne d'émission du second transistor (M2) sont connectées à un autre circuit résonnant (C1, L1p, L1n) de l'amplificateur différentiel.

4. Amplificateur différentiel selon la revendication 3, dans lequel en ce qui concerne le signal en mode symétrique, la fréquence de résonance des deux circuits résonnants ([C0, L0p, L0n], [C1, L1p, L1n]) ont une valeur identique, compte tenu des tolérances de fabrication.

5. Amplificateur différentiel selon l'une quelconque des revendications précédentes, dans lequel le premier inducteur (L0p, L1p, L2p) et le second inducteur (LOn, L1n, L2n) sont formés par enroulements symétriques de bobine.

6. Amplificateur différentiel selon l'une quelconque des revendications précédentes, dans lequel le premier inducteur (L0p, L1p, L2p) et le second inducteur (L0n, L1n, L2n) sont formés grâce à une bobine intégrée présentant un point médian.

7. Amplificateur différentiel selon l'une quelconque des revendications précédentes, construit pour servir d'amplificateur sélectif afin d'amplifier une fréquence de fonctionnement, dans lequel une résonance des circuits résonnants ([CO, LOp, LOn], [C1, L1p, L1n], [C2, L2p, L2n]) est de 2,4GHz compte tenu des tolérances de fabrication.

8. Amplificateur différentiel selon l'une quelconque des revendications précédentes, présentant deux étages d'amplification en cascade,

- dans lequel le premier étage d'amplification comprend le premier transistor (M1) et le second transistor (M2),
- dans lequel le second étage d'amplification comprend un troisième transistor (M3) et un quatrième transistor (M4),
- dans lequel le premier étage d'amplification et le second étage d'amplification fonctionnent grâce à un courant de fonctionnement identique, qui s'écoule à travers le premier étage d'amplification tout comme à travers le second étage d'amplification.

9. Amplificateur différentiel selon la revendication 8,

- dans lequel le troisième transistor (M3) et le quatrième transistor (M4) sont chacun reliés respectivement dans un circuit de source ou un circuit d'émission,
- dans lequel respectivement une troisième borne de grille (G3) ou une troisième borne de base du troisième transistor (M3) est connectée *via* un premier condensateur de couplage (CKp) respectivement à la première borne de drain (D1) ou à la première borne collectrice du premier transistor (M1), et
- dans lequel respectivement une quatrième borne de grille (G4) ou une quatrième borne de base du quatrième transistor (M4) est connectée *via* un second condensateur de couplage (CKn) respectivement à la deuxième borne de drain (D2) ou à la deuxième borne collectrice du second transistor (M2).

10. Amplificateur différentiel selon la revendication 8 ou 9,

- comprenant un cinquième transistor (M5), qui est connecté avec le troisième transistor (M3) afin de former un premier étage cascode,
- comprenant un sixième transistor (M6), qui est connecté avec le quatrième transistor (M4) afin de former un second étage cascode,

11. Amplificateur différentiel selon la revendication 8 ou 9,

- comprenant un premier condensateur de neutralisation (M5'), qui est connecté au troisième transistor (M3) et au quatrième transistor (M4) pour neutraliser la capacité de Miller du troisième transistor (M3), et
- comprenant un second condensateur de neutralisation (M6'), qui est connecté au quatrième transistor (M4) et au troisième transistor (M3) pour neutraliser la capacitance de Miller du quatrième transistor (M4).

12. Amplificateur différentiel selon la revendication 11, dans lequel

- le premier condensateur de neutralisation est formé à partir d'un cinquième transistor (M5') et
- le second condensateur de neutralisation est formé à partir d'un sixième transistor (M6').

13. Amplificateur différentiel selon l'une quelconque des revendications 8 à 11, comprenant un circuit résonnant supplémentaire (C2, L2p, L2n) qui est une charge pour le second étage d'amplification, dans lequel le circuit résonnant (C2, L2p, L2n) est connecté au troisième transistor (M3) et au quatrième transistor (M4) ou au cinquième transistor (M5) et au sixième transistor (M6) pour former le second étage d'amplification.

14. Système radio destiné à la communication, doté d'un amplificateur différentiel selon l'une quelconque des revendications précédentes pour amplifier une fréquence de transmission de 2,4 GHz.

FIG.1

FIG.2

FIG.3

FIG.4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6392486 B1
- EP 1067679 A2

**In der Beschreibung aufgeführte Nicht-Patentliteratur**

- Analoge Schaltungen. Verlag Technik, 1994, 107 ff
- **GRAMEGNA G.** An 8.2-ghz, 14.4mw, 1.6db nf sige bipolar Ina with dc current reuse. *PROCEEDINGS OF THE 2003 BIPOLAR/BICMOS CIRCUITS AND TECHNOLOGY MEETING. (BCTM), Toulouse, France, Sept. 28-30, 2003, IEEE BIPOLAR/BICMOS CIRUITS AND TECHNOLOGY MEETING,* 28. September 2003, 49-52
- **CHE-HONG LIAO et al.** A 5.7-GHz 0.18-um CMOS Gain-Controlled Differential LNA With Current Reuse for WLAN Receiver. *IEEE MICROWAVE AND WIRELESS COMPUENTS LETTERS,* 2003, vol. 13 (12
- **RAGONESE E et al.** A 5-GHz monolithic silicon bipolar down-converter with on-chip image filtering. *ELECTROTECHNICAL CONFERENCE, 2004. MELECON 2004, PROCEEDINGS OF THE 12 TH IEEE MEDITERRANEAN DUBROVNIK,* 12. Mai 2004, vol. 1, ISBN 978-0-7803-8271-8, 159-162
- **GRAMEGNA G et al.** 23mm 2single_chip 0.18/spl mu/m CMOS GPS receiver with 28 mW-4.1 mm 2radio and CPU/DSP/RAM/ROM. *CUSTOM INTEGRATED CIRCUITS CONFERENCE, 2004. PROCEEDINGS OF THE IEEE 2004,* 03. Oktober 2004, ISBN 978-0-7803-8495-8, 81-84
- *IEEE Journal of Solid-State Circuits,* Februar 2003, vol. 38 (2), 176 ff
- *IEEE Journal of Solid-State Circuits,* April 2003, vol. 38 (4